(19) Europäisches Patentamt
European Patent Office
Office européen des brevets

(11) **EP 2 393 193 A1**

(12) **DEMANDE DE BREVET EUROPEEN**

(43) Date de publication:
**07.12.2011 Bulletin 2011/49**

(51) Int Cl.:
*H02M 3/158* (2006.01)    *H02J 3/38* (2006.01)
*H03K 17/12* (2006.01)

(21) Numéro de dépôt: **11168131.8**

(22) Date de dépôt: **30.05.2011**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **04.06.2010 FR 1054422**

(71) Demandeur: **Commissariat à l'Énergie Atomique et aux Énergies Alternatives**
**75015 Paris (FR)**

(72) Inventeurs:
• **Waltisperger, Guy**
  **38000 GRENOBLE (FR)**
• **Condemine, Cyril**
  **38140 Izeaux (FR)**
• **Willemin, Jérôme**
  **38120 Tullins (FR)**

(74) Mandataire: **Croonenbroek, Thomas Jakob**
**Cabinet Innovincia**
**11, avenue des Tilleuls**
**74200 Thonon-les-Bains (FR)**

(54) **Circuit convertisseur et système électronique comportant un tel circuit**

(57)      L'invention concerne un circuit convertisseur (2) destiné à être relié à une source d'énergie électrique (3) susceptible de fluctuations importantes de puissance délivrée, comprenant :
- un circuit de hachage (11) à rapport cyclique ($\alpha$) variable, comprenant un commutateur de hachage (13) à dimension réglable et une borne d'entrée (9) susceptible d'être reliée à ladite source d'énergie électrique (3), et

- au moins un premier circuit de sortie (14) adapté à être connecté via un commutateur (17) à dimension réglable à une borne de sortie (19) du circuit de hachage (11),
- un circuit de commande (51) configuré pour commander d'une part le rapport cyclique ($\alpha$) du circuit de hachage et d'autre part la dimension desdits commutateurs (13,17) à dimension réglable en fonction de la puissance délivrée par ladite source d'énergie électrique (3).

**FIG. 1**

Printed by Jouve, 75001 PARIS (FR)

**Description**

La présente invention concerne un circuit convertisseur et un système électronique comportant un tel circuit.

Le développement des panneaux photovoltaïques a pris un essor très important ces dernières années afin d'utiliser de plus en plus des sources d'énergie renouvelables permettant de réduire l'effet de serre néfaste provoqué en particulier par l'émission du dioxyde de carbone.

Il en est de même des sources d'énergie renouvelables comme les éoliennes ou des sources thermoélectriques.

Ces sources d'énergie ont la particularité que l'énergie électrique fournie par ces sources varie fortement en fonction des phénomènes naturels qui les alimentent. De plus, un générateur photovoltaïque est un générateur dont la caractéristique $I = f(U)$ est fortement non-linéaire. Ainsi, pour un même éclairement, la puissance délivrée sera différente selon la charge.

Ainsi, le rendement, c'est-à-dire la puissance délivrée d'une cellule photovoltaïque dépend non seulement de son exposition au soleil qui varie au cours de la journée, mais aussi par exemple de l'occultement du soleil, par exemple par l'ombre portée par des nuages ou d'autres phénomènes météorologiques.

Pour transférer de l'énergie produite par ces sources, on utilise des convertisseurs DC-DC en sortie de la source de récupération d'énergie. Un tel convertisseur DC-DC peut être un convertisseur hacheur permettant d'élever ou de diminuer la tension délivrée par la source d'énergie électrique. I1 comporte généralement des commutateurs de puissance, en particulier des transistors (par exemple du type à effet de champ MOSFET (« metal oxide semiconductor field effect transistor » en anglais), à transition JFET (« junction field effect transistor » en anglais) ou à transistors bipolaires BJT (« bipolar transistors » en anglais)) pour le transfert de l'énergie vers un circuit de sortie.

Toutefois, selon un premier aspect, ces interrupteurs sont également à l'origine de pertes dans la récupération d'énergie, ce qui peut affecter le rendement global de récupération d'énergie.

En particulier, il convient de noter des pertes résistives et des pertes de commutation de ces composants électroniques.

Si le convertisseur DC - DC est conçu pour des courants plus forts, il est nécessaire d'avoir des commutateurs de puissance de grande dimension.

Cependant, lorsque le courant prélevé est faible, la consommation dynamique pour la commutation fait chuter le rendement global du système.

Si le convertisseur DC - DC est conçu pour des courants faibles, il est nécessaire d'avoir des commutateurs de puissance de petite dimension.

Cependant, lorsque le courant prélevé est fort, ces commutateurs présentent une perte résistive importante ce qui fait également chuter le rendement global du système.

A présent, on est donc confronté de trouver un compromis adéquat pour choisir la dimension des interrupteurs de puissance.

Par ailleurs, selon un second aspect, quand des cellules photovoltaïques sont par exemple connectées à une charge comme un consommateur (par exemple un capteur ou encore une batterie à recharger), il s'avère que la puissance transférée à la charge ne correspond généralement pas à la puissance maximale qui pourrait être délivrée par la cellule. On remarque des problèmes similaires dans le cas du éolien. Il en résulte que le rendement chute non seulement à cause par exemple d'un ensoleillement plus faible, mais ce rendement est en plus grevé par un point de fonctionnement imposé se situant en dessous des performances potentielles de la cellule.

Afin de palier cet inconvénient et pour produire toujours de l'énergie le plus proche du point de fonctionnement optimal, on utilise des circuits mettant en oeuvre une méthode appelé Maximum Power Point Tracking (MPPT) (méthode de recherche de la puissance maximale) qui ont été développés depuis 1968. Il s'agit d'assurer une meilleure connexion entre une source non linéaire et une charge arbitraire.

Ces circuits sont conçus pour forcer le générateur, tel que la cellule photovoltaïque, à travailler à son point de fonctionnement maximum (« Maximum power point » pour point de puissance maximale en anglais) ce qui induit un rendement amélioré.

Un contrôleur MPPT permet donc de piloter le convertisseur statique reliant la charge (une batterie par exemple) et le panneau photovoltaïque de manière à fournir en permanence le maximum de puissance à la charge.

Il est connu de mettre en oeuvre pour la recherche du point maximal de puissance MPP (*MPP, Maximum Power Point* en anglais) une méthode basée sur une méthode perturbation-observation.

Dans le cas d'une application photovoltaïque, il s'agit en fait d'un algorithme qui, pour une tension U1 fixée, va mesurer la puissance correspondante P1 délivrée par le générateur, puis, après un certain temps, l'algorithme impose une tension $U2 = U1 + \Delta U$ et mesure également la puissance correspondante P2. Par la suite, on impose une tension U3 = $U2 + \Delta U$, si P2 est supérieure à P1 ou U3 = $U2 - \Delta U$ dans le cas contraire.

Toutefois, cela implique des mesures de courant et aussi des moyens de calculs importants dont la consommation énergétique est non négligeable. C'est pourquoi dans une installation photovoltaïque de grande taille, un sous-groupe de cellules est exclusivement dédié à fournir l'énergie nécessaire pour le contrôle du circuit MPPT.

Cependant, dans des microsystèmes électroniques, comme par exemple des capteurs autonomes, cette approche n'est pas acceptable, car les contraintes en termes d'encombrement et de poids sont fortes, et il est nécessaire d'avoir un système le plus petit possible avec une autonomie accrue.

On connaît aussi des circuits de recherche du point de fonctionnement de puissance maximale possédant une cellule pilote supplémentaire, ce qui n'est pas toujours souhaitable.

Il est également connu des circuits MPPT sans cellule pilote qui se basent sur un échantillonnage de la tension en circuit ouvert en déconnectant à fréquence fixe le panneau photovoltaïque avec le reste du circuit pour mesurer la tension en circuit ouvert. Le système reconnecte alors le panneau au circuit de récupération qui a pris en compte les nouveaux paramètres optimisés. Mais il en résulte une interruption fréquente du processus de récupération d'énergie, ce qui n'est pas admissible pour des microsystèmes électroniques à vocation autonome.

Par ailleurs, dans le domaine informatique, on connaît du document US2006/0038543 un circuit convertisseur DC-DC utilisant des commutateurs de puissance à dimension réglable pour réduire les pertes liées aux commutateurs.

Toutefois, le circuit décrit dans ce document est conçu pour s'adapter à un environnement déterminé par la consommation et les besoin de la charge et n'est pas adapté pour des sources d'énergie susceptibles de fluctuations importantes de la puissance délivrée.

La présente invention vise à palier ces inconvénients précités, au moins en partie.

Selon un aspect, on cherche à diminuer les pertes du circuit convertisseur.

Selon un autre aspect, on vise à optimiser la récupération d'énergie tout en permettant une réduction sensible de l'encombrement du système, en particulier la taille du générateur par exemple photovoltaïque ou éolien, mais aussi de l'accumulateur de secours, par exemple une pile ou un supercondensateur.

A cet effet, la présente invention propose un circuit convertisseur destiné à être relié à une source d'énergie électrique susceptible de fluctuations importantes de puissance délivrée, comprenant :

- un circuit de hachage à rapport cyclique variable, comprenant un commutateur de hachage à dimension réglable et une borne d'entrée susceptible d'être reliée à ladite source d'énergie électrique, et
- au moins un premier circuit de sortie adapté à être connecté via un commutateur à dimension réglable à une borne de sortie du circuit de hachage,
- un circuit de commande configuré pour commander d'une part le rapport cyclique du circuit de hachage et d'autre part la dimension desdits commutateurs à dimension réglable en fonction de la puissance délivrée par ladite source d'énergie électrique.

Selon une ou plusieurs caractéristiques du circuit convertisseur, prises seules ou en combinaison :

Selon un aspect, le circuit de commande est configuré pour commander la dimension desdits commutateurs à dimension réglable en fonction du rapport cyclique ($\alpha$).

Selon un autre aspect, le circuit de commande est configuré pour rechercher le point maximum de puissance (MPPT).

Cette méthode MPPT est par exemple mise en oeuvre par le circuit de commande configuré pour déterminer un point de fonctionnement (MPPT) en fonction de la variation de tension de ladite source d'énergie électrique.

Selon encore un autre aspect, chacun desdits commutateurs à dimension réglable comprend au moins deux commutateurs individuels disposés en parallèle et commutables sélectivement en fonction d'une commande dudit circuit de commande.

Selon une première variante, les commutateurs individuels sont de mêmes dimensions.

Selon une deuxième variante alternative, les commutateurs individuels possèdent des dimensions croissantes.

Dans ce dernier cas, on peut par exemple prévoir que les commutateurs individuels possèdent des dimensions croissantes par des multiples de deux.

Selon encore un autre aspect, le circuit de commande est configuré pour commander une augmentation de la dimension desdits commutateurs à dimension réglable en fonction d'une augmentation de la puissance délivrée par ladite source d'énergie.

On peut aussi prévoir que le circuit de commande est configuré pour commander la dimension desdits commutateurs à dimension réglable en fonction de plages de consigne prédéfinies de puissance délivrées par ladite source d'énergie.

Le circuit de commande peut être configuré pour commander le circuit de hachage selon un fonctionnement discontinu.

Selon un autre développement, le circuit convertisseur comprend un second circuit de sortie adapté à être connecté via un second commutateur réglable en dimension à la borne de sortie du circuit de hachage, et dans lequel le circuit de commande est configuré pour commander la commutation des premier et second commutateurs en fonction d'une plage de consigne de tension de sortie pour le premier circuit de sortie.

Selon un aspect, le premier circuit de sortie est destiné à être raccordé à une charge électrique fonctionnant dans la plage de consigne de tension et dans lequel le second circuit de sortie est destiné à être raccordé à un accumulateur d'énergie électrique.

Selon un autre aspect le circuit de commande comporte un comparateur à hystérésis dont une entrée est raccordée au premier circuit de sortie et dont l'autre entrée est raccordée à une référence, la sortie du comparateur étant raccordée à une entrée d'une unité de commande commandant un générateur de commande dont deux sorties sont respectivement reliées aux premier et second commutateurs pour leur pilotage respectif.

Par ailleurs, l'accumulateur d'énergie électrique peut être une micro-pile rechargeable, et/ou un supercondensateur.

Les circuits de sortie comprennent par exemple des filtres passe - bas.

Selon encore un autre aspect, le circuit de commande comprend en outre des moyens pour

o déterminer la tension aux bornes de ladite source d'énergie électrique pour deux rapports cycliques différents d'une quantité prédéfinie,
o calculer la différence entre les tensions obtenues pour deux rapports cycliques différents d'une quantité prédéfinie,
o comparer cette différence de tension avec une valeur de différence de tension obtenue précédemment, et
o commander un changement du rapport cyclique d'une quantité prédéfinie en fonction du résultat de comparaison.

On prévoit par exemple que le circuit de commande est configuré pour commander une augmentation du rapport cyclique d'une quantité prédéfinie si une diminution précédente du rapport cyclique a eu pour résultat une diminution de la différence de tension par rapport à celle obtenue lors de la détermination précédente.

Puis, le circuit de commande peut être configuré pour commander une diminution du rapport cyclique d'une quantité prédéfinie si une augmentation précédente du rapport cyclique a eu pour résultat une diminution de la différence de tension par rapport à celle obtenue lors de la détermination précédente.

Selon un exemple non limitatif, le circuit de hachage comprend une inductance d'accumulation d'énergie électrique et au moins un commutateur de hachage commandé par le circuit de commande.

Selon une première variante, l'inductance d'accumulation d'énergie électrique et le commutateur de hachage sont disposés selon une configuration élévateur de tension.

Selon une variante alternative, l'inductance d'accumulation d'énergie électrique et le commutateur de hachage sont disposés selon une configuration abaisseur de tension.

Le circuit de commande peut comporter un capteur de courant « zéro » de l'inductance d'accumulation d'énergie électrique pour déclencher la commande d'au moins un commutateur.

L'invention a également pour objet un système électronique comprenant au moins une source d'énergie électrique susceptible de fluctuations importantes et au moins un circuit convertisseur tel que défini ci-dessus relié à ladite au moins une source d'énergie.

Selon une ou plusieurs caractéristiques du système électronique, prises seules ou en combinaison,

- ladite source comprend au moins une cellule photovoltaïque,
- ladite source comprend au moins une éolienne,
- ladite source comprend au moins un élément thermoélectrique,
- la sortie de chaque source d'énergie est reliée à l'entrée d'un circuit convertisseur associé et chacun des seconds circuits de sortie des circuits convertisseurs comprend un supercondensateur.

D'autres avantages et caractéristiques apparaîtront à la lecture de la description de l'invention, ainsi que des figures suivantes sur lesquelles :

- la figure 1 présente un schéma d'un système électronique avec un circuit convertisseur selon un premier mode de réalisation,
- la figure 2 présente un exemple d'un schéma de circuit électrique d'un commutateur à dimension réglable,
- la figure 3 présente un organigramme permettant d'illustrer la méthode de recherche du maximum du point de puissance,
- la figure 4 présente un schéma d'un système électronique avec un circuit convertisseur selon un second mode de réalisation,
- la figure 5 présente un graphique schématique des commandes des transistors du circuit convertisseur selon le second mode de réalisation en fonction du temps.
- la figure 6 présente un schéma d'un système électrique selon un autre mode de réalisation.

Sur toutes les figures, les éléments identiques portent les mêmes numéros de référence.

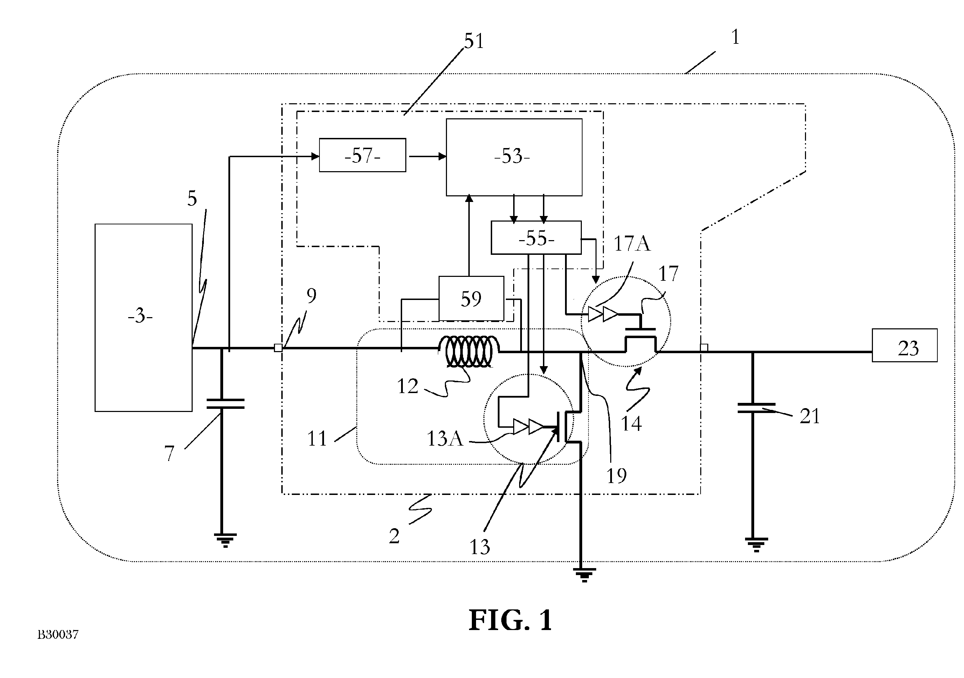

La figure 1 présente un exemple de réalisation d'un schéma d'un système électronique 1 comprenant un circuit convertisseur 2 et une source d'énergie électrique 3, reliée au circuit convertisseur 2.

En ce qui concerne la source d'énergie électrique 3 susceptible de fluctuations importantes de la puissance délivrée, il s'agit par exemple d'une cellule ou d'un panneau solaire, d'un élément thermoélectrique ou encore d'une éolienne, en particulier de petite taille.

Par fluctuations importantes, on entend des fluctuations d'environ d'un facteur cent entre la puissance la plus faible et la puissance la plus forte pouvant être délivrée par une telle source 3.

Une sortie 5 de cette source 3 est raccordée via un filtre passe-bas 7, réalisé par un condensateur, à une borne d'entrée 9 du circuit convertisseur 2.

Le circuit convertisseur 2 comprend un circuit de hachage 11 dont la borne d'entrée forme la borne d'entrée 9 du circuit convertisseur 2 reliée à ladite source d'énergie électrique 3.

Le circuit de hachage 11 comprend d'une part une inductance d'accumulation d'énergie électrique 12 et au moins un commutateur de hachage 13 à dimension réglable.

Sur la figure 1, l'inductance d'accumulation d'énergie électrique 12 et le commutateur de hachage 13 à dimension réglable sont disposés selon une configuration élévateur de tension (également appelé « configuration boost »), c'est-à-dire que l'entrée de l'inductance est reliée à la source 3 et la sortie de l'inductance 12 peut être reliée à la masse si le commutateur 13 est à l'état passant pour permettre l'établissement d'un champ magnétique autour de l'inductance 12. La fréquence de hachage est par exemple de 200kHz.

Selon une variante non représentée, l'inductance d'accumulation d'énergie électrique 12 et le commutateur de hachage 13 peuvent également être disposés selon une configuration abaisseur de tension

Le circuit convertisseur comprend de plus un premier circuit de sortie 14.

En amont, ce premier circuit de sortie 14 est connecté via un premier commutateur 17 à dimension réglable à une borne de sortie 19 du circuit de hachage 11.

En aval, ce premier circuit de sortie 14 est raccordé via un filtre passe-bas 21 à une charge électrique 23 appartenant au système électronique 1 et fonctionnant dans une plage de consigne de tension prédéfinie.

Pour optimiser la consommation électrique du convertisseur, aussi bien le commutateur 13 que le commutateur 17 sont donc des commutateurs à dimension réglable.

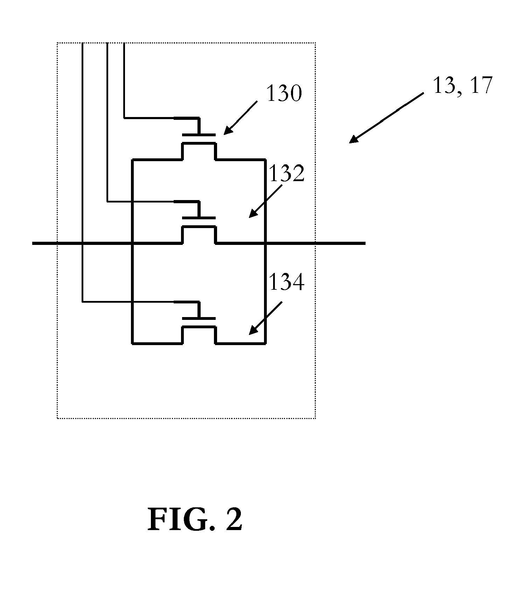

A titre d'exemple, une réalisation possible d'un commutateur à dimension réglable est représentée à la figure 2.

Ainsi, un commutateur 13 ou 17 à dimension réglable sur la figure 1 correspond à un ensemble de plusieurs commutateurs en parallèle comme cela est représenté sur la figure 2.

Par exemple, chacun desdits commutateurs 13 et 17 à dimension réglable comprend au moins deux, sur la figure trois commutateurs 130, 132 et 134 individuels disposés en parallèle et commutables sélectivement en fonction d'une commande.

On peut prévoir que ces commutateurs individuels 130, 132 et 134 sont tous de même dimensions, c'est-à-dire identiques.

Ainsi, s'il y a besoin d'un commutateur de petite taille, donc avec de faibles pertes de commutation mais avec des pertes résistives plus grandes, un seul des commutateurs individuels est commuté à l'état passant.

S'il y a besoin d'un commutateur de grande taille, donc avec de faible pertes résistives mais avec des pertes de commutation plus grandes, plusieurs voir tous les commutateurs individuels sont commutés simultanément à l'état passant.

En variante, on peut prévoir que les commutateurs individuels 130, 132 et 134 possèdent des dimensions croissantes en particulier des dimensions croissantes par des multiples de deux, c'est-à-dire que la dimension du commutateur individuel 134 est le double du commutateur 132 qui lui-même est le double du commutateur 130.

Ainsi, on peut étendre la gamme de dimensions par des combinaisons judicieuses de commutateurs commutés simultanément à l'état passant.

Le pilotage du circuit convertisseur 2 est assuré par un circuit de commande 51.

Ce circuit de commande 51 présente une unité de commande 53 commandant d'une part le rapport cyclique $\alpha$ du circuit de hachage 11 et donc de son commutateur 13 à dimension réglable et d'autre part la commutation du premier 17 commutateur à dimension réglable comme cela va être détaillé ci-après.

A cet effet, l'unité de commande 53 comprend une sortie PWM (pour « pulse width modulation », c'est-à-dire modulation de largeur d'impulsion pulse en anglais) commandant un générateur 55 de commande des commutateurs 13 et 17 (également appelé unité DTLC pour « dead time logic control » à savoir commande logique de temps mort en anglais).

Concernant le commutateur 13, il est à noter qu'il s'agit de transistors du type NMOS dont la base est reliée via des buffers (également appelé des lignes de retard) 13A à la sortie du générateur 55.

Pour le commutateur 17, il s'agit de transistors PMOS dont la base est reliée via des buffers 17A à des sorties associées du générateur 55.

Le circuit de commande 51 comprend de plus des moyens pour déterminer la tension aux bornes de ladite source d'énergie électrique à deux instants successifs.

A cet effet, on utilise par exemple un convertisseur analogique - numérique 57 dont une entrée est raccordée à la borne 5 et dont une sortie est raccordée à une entrée correspondante de l'unité de commande 53.

Pour la commande en particulier du commutateur 17, le circuit de commande 51 comprend un capteur 59 de courant « zéro » pour déterminer l'annulation du courant à travers l'inductance d'accumulation 12, ce capteur 59 délivrant un signal à une entrée correspondante de l'unité de commande 53.

Selon une variante non représentée, on peut envisager de remplacer le capteur de courant « zéro » par une diode à très faible seuil de tension en parallèle avec un commutateur.

Pour le fonctionnement, l'unité de commande 53 commande le générateur 5 5 de façon que

- quand le commutateur 13 est fermé (état passant), le commutateur 17 est ouvert (étant bloquant),
- quand le commutateur 17 est fermé (état passant), le commutateur 13 est ouvert (état bloquant).

Ainsi, à un moment donné, seul un des commutateurs 13 ou 17 peut être à l'état ouvert.

Le circuit de commande peut être configuré pour commander le circuit de hachage 11 selon un fonctionnement discontinu, c'est-à-dire que le courant s'annule périodiquement dans l'inductance 12.

Par la suite, on va détailler le fonctionnement du circuit convertisseur 2 de la figure 1.

Le circuit de commande 51 est configuré pour commander d'une part le rapport cyclique $\alpha$ du circuit de hachage 11 et d'autre part la dimension desdits commutateurs 13 et 17 à dimension réglable en fonction de la puissance délivrée par ladite source d'énergie électrique 3.

Les inventeurs ont pu constater qu'il existe un rapport de proportionnalité entre la puissance délivrée par la source 3 et le rapport cyclique $\alpha$. En effet, la puissance délivrée augmente en fonction du rapport cyclique.

Ainsi, le circuit de commande 51 est configuré pour commander une augmentation de la dimension desdits commutateurs 13 et 17 à dimension réglable en fonction d'une augmentation de la puissance délivrée par ladite source d'énergie ou plus simplement en fonction du rapport cyclique $\alpha$.

Pour la mise en oeuvre, par exemple le circuit de commande 51 est configuré pour commander la dimension desdits commutateurs 13 et 17 à dimension réglable en fonction de plages de consigne prédéfinies de puissance délivrées par ladite source d'énergie 3.

En plus du fait d'adapter la dimension des commutateurs 13 et 17, on prévoit de faire fonctionner la source 3 toujours autour du point maximal de puissance MPP.

Il s'est relevé très avantageux de considérer une combinaison consistant à déterminer le rapport cyclique $\alpha$ selon une méthode MPPT, de manière de prélever de l'énergie au point de fonctionnement optimal et d'utiliser ce rapport cyclique optimal pour commander des dimensions des commutateurs 13 et 17.

A cet effet, les inventeurs de la présente invention ont constaté que la dérivée de la tension de fonctionnement de la source 3 en fonction du rapport cyclique présente un maximum autour du point maximal de puissance MPP. Il en résulte que la recherche du maximum de cette dérivée de tension équivaut à la recherche du point maximal de puissance.

Ainsi, comme on va le voir, grâce à de simples mesures de tensions et des opérations de soustractions et de comparaison qui sont très peu gourmandes en énergie et en puissance de calcul, on peut faire fonctionner le circuit convertisseur 2 autour du point maximal de puissance MPP, ce qui est très avantageux si peu de puissance est disponible.

De plus, on peut ainsi réduire les pertes au niveau des commutateurs sans faire de mesures spécifiques.

A cet effet, l'unité de commande 53 commande le rapport cyclique $\alpha$ du circuit de hachage 11 en fonction de la variation de tension (la dérivée en fonction du rapport cyclique) de ladite source d'énergie électrique

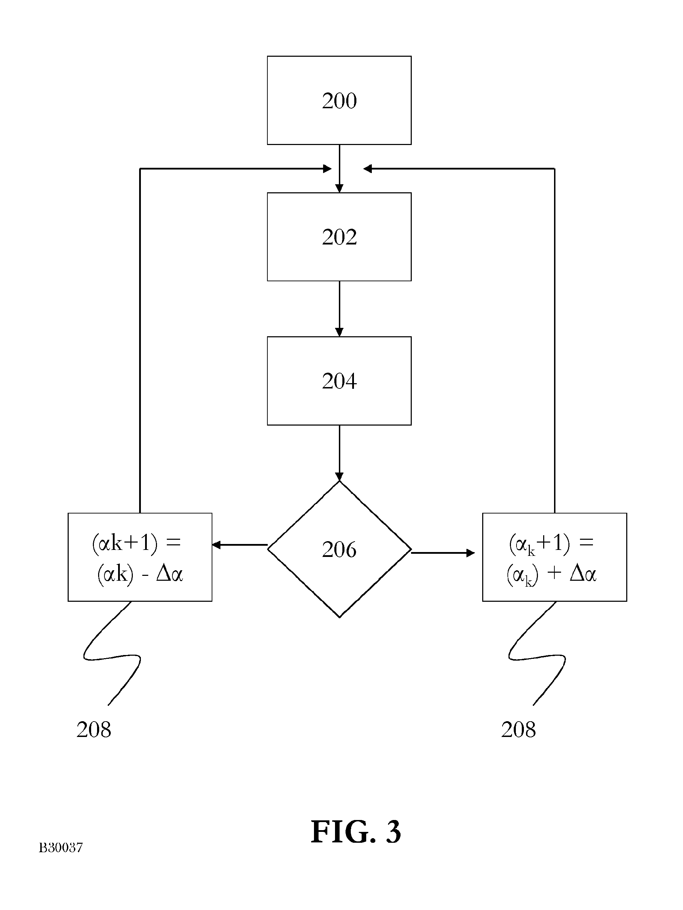

- en déterminant la tension aux bornes de ladite source d'énergie électrique pour deux rapports cycliques différents d'une quantité prédéfinie,
- en calculant la différence entre les tensions obtenues pour deux rapports cycliques différents d'une quantité prédéfinie,
- en comparant cette différence de tension avec une valeur de différence de tension obtenue précédemment, et
- en commandant un changement du rapport cyclique d'une quantité prédéfinie en fonction du résultat de comparaison. Ces différentes étapes sont détaillées à la figure 3.

Lors d'une étape d'initialisation 200, on règle la valeur du rapport cyclique $\alpha$ à une valeur prédéfinie, par exemple à $\alpha = 0,5$ et on détermine la tension $V_s (\alpha)$ aux bornes de la source 3.

Puis, on fait varier le rapport cyclique d'une quantité prédéfinie $\Delta\alpha$, et, on détermine à nouveau la tension $V_s (\alpha+\Delta\alpha)$ aux bornes de ladite source d'énergie électrique 3.

Ensuite, on calcule la valeur absolue de la différence entre ces deux tensions :

$$\Delta V^{ini}_s = |V_s(\alpha) - V_s(\alpha + \Delta\alpha)|$$

En variante, on peut aussi fixer $\Delta V^{ini}_s$ à une valeur prédéfinie.

Puis commence la boucle de réglage par récurrence proprement dite.

Lors d'une étape 202 pour une boucle k (k étant un nombre entier), on détermine la tension $V_s(\alpha_k)$ aux bornes de la source 3.

Lors d'une étape 204, on calcule la valeur absolue de la différence entre les deux tensions mesures pour la boucle k et k-1:

$$\Delta V_s(k) = |V_s(\alpha_k) - V_s(\alpha_{k-1})| \; ; \; où \; |(\alpha_k) - (\alpha_{k-1})| = \Delta\alpha$$

Ensuite, lors de l'étape 206, on compare cette différence de tension $\Delta V_s(k)$ avec une valeur de différence de tension obtenue précédemment $\Delta V_s(k-1)$.

En fonction du résultat de comparaison, l'unité de commande 53 commande le changement du rapport cyclique d'une quantité prédéfinie $\Delta\alpha$ lors de l'étape 208.

Ainsi, le circuit de commande 51 est configuré pour commander une augmentation du rapport cyclique la quantité prédéfinie $\Delta\alpha$ si une diminution précédente du rapport cyclique a eu pour résultat une diminution de la différence de tension par rapport à celle obtenue lors de la détermination précédente.

Autrement dit, si $(\alpha_k) = (\alpha_{k-1}) - \Delta\alpha$ et si $\Delta V_s(k) < \Delta V_s(k-1)$, alors $(\alpha_{k+1}) = (\alpha_k) + \Delta\alpha$.

Dans le cas contraire, le circuit de commande est 51 configuré pour commander une diminution du rapport cyclique d'une quantité prédéfinie $\Delta\alpha$ si une augmentation précédente du rapport cyclique a eu pour résultat une diminution de la différence de tension par rapport à celle obtenue lors de la détermination précédente,

Autrement dit, si $(\alpha_k) = (\alpha_{k-1}) + \Delta\alpha$ et si $\Delta V_s(k) < \Delta V_s(k-1)$, alors $(\alpha_{k+1}) = (\alpha_k) - \Delta\alpha$.

Après l'étape 208, on revient à l'étape 202.

Ainsi, le circuit convertisseur oscille autour du point de fonctionnement maximal MPP, ce qui garantit de récupérer un maximum de puissance disponible à la source.

La fréquence de recherche du point maximum de puissance MPP ou fréquence de rafraîchissement du rapport cyclique, c'est-à-dire la fréquence pour réaliser les étapes 202 à 208, est de l'ordre d'une dizaine de Hertz, par exemple de 16Hz.

On peut prévoir que la fréquence d'adaptation de la dimension des commutateurs 13 et 17 va de paire avec la fréquence de recherche du point maximum de puissance MPP.

On constate en outre que plus $\Delta\alpha$ est petit, plus le circuit peut fonctionner proche du point optimal maximum de puissance. Dans ce cas, on choisira une fréquence de rafraîchissement plus élevée pour permettre une adaptation plus rapide du rapport cyclique en cas de changement des conditions de fonctionnement.

Comme cela a été dit précédemment, lorsque le commutateur 13 est fermé, le commutateur 17 est ouvert et l'inductance est parcourue par un courant fourni par la source 3 établissant un champ magnétique.

Puis, le commutateur 13 est ouvert et l'énergie électrique peut être fournie directement à la charge 23. Le circuit de sortie 14 fonctionne donc ensemble avec le circuit de hachage 11 comme un régulateur de tension.

Ainsi, lorsque le commutateur 13 est ouvert, le commutateur 17 s'ouvre si la tension de sortie est comprise dans une plage de consigne de tension de sortie.

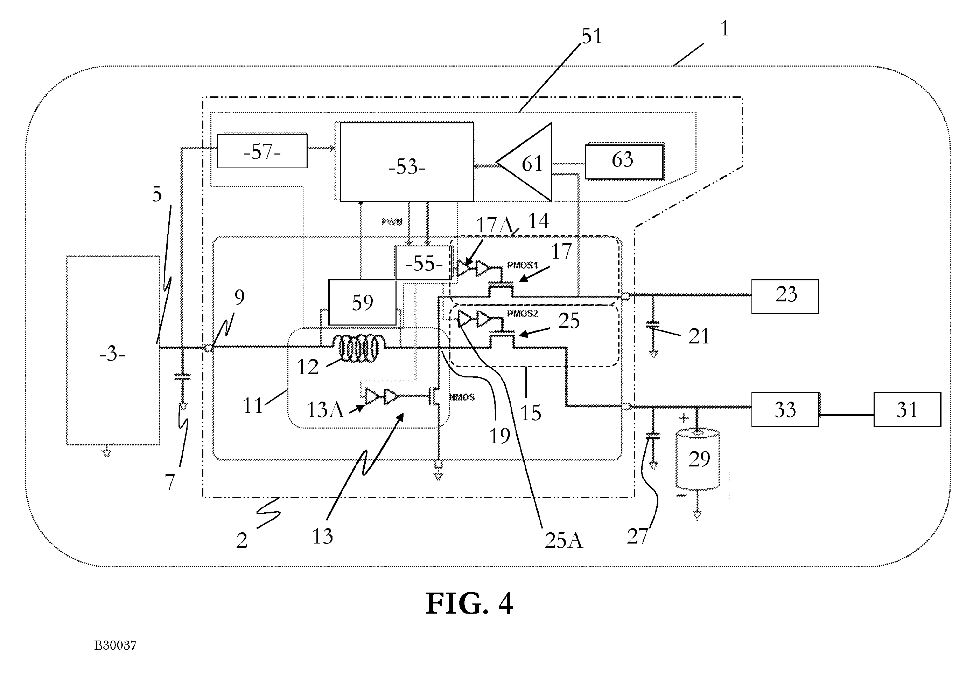

On se réfère maintenant à la figure 4 montrant un autre mode de réalisation de la présente invention.

Ce mode de réalisation se distingue de celui de la figure 1 par le fait que le circuit convertisseur 2 comporte un second circuit de sortie 15.

Tandis que le premier circuit de sortie est relié à la charge électrique 23 pour une consommation directe, le second circuit de sortie 15 est relié à un accumulateur électrique 29 afin d'y être stocké temporairement pour une consommation ultérieure.

Ceci permet d'augmenter la quantité d'énergie prélevé de ladite source électrique 3.

En amont, le second circuit de sortie 15 est connecté via un second commutateur à dimension réglable 25 à la borne de sortie 19 du circuit de hachage 11.

En aval, le second circuit de sortie 15 est raccordé via un filtre passe-bas 27 à un accumulateur d'énergie électrique 29 appartenant au système électronique 1.

Cet accumulateur 29 peut être un condensateur, un supercondensateur, une batterie, une micro-pile ou une mini-batterie.

Comme cela est montré sur la figure 4, afin de permettre une alimentation contrôlée d'une charge électrique 31 en aval de l'accumulateur électrique 29, on peut prévoir un régulateur de tension DC-DC 33.

Si l'accumulateur d'énergie électrique 29 est une batterie, une micro-pile ou une mini-batterie, il est prévu de prévoir un circuit chargeur entre le filtre passe-bas 27 et l'accumulateur 29 pour permettre la charge de la batterie suivant les conditions associées à la technologie de la batterie afin d'éviter un échauffement et/ou une dégradation prématurée.

Selon une première variante, la charge 31 et la charge 23 sont identiques. Dans ce cas, l'accumulateur d'énergie électrique 29 sert par exemple pour alimenter la charge 23 lorsque l'énergie produite par la source 3 n'est pas suffisante pour une alimentation directe de la charge 23. Dans le cas d'une cellule photovoltaïque comme source d'énergie électrique 3, ceci peut être le cas par exemple la nuit ou lorsque l'ensoleillement est trop faible, par exemple en cas de ciel nuageux.

Selon une seconde variante, les charges 23 et 31 sont différentes et correspondent à des consommateurs électriques différents.

On conçoit aisément que la maîtrise des pertes de commutateurs 13, 17 et 19 est importante étant donné que l'on a augmenté le nombre de commutateurs et le nombre de commutations par cycle de charge / décharge. Le fait de commander en outre la dimension des commutateurs 13, 17 et 25 en fonction de la puissance délivrée par la source d'énergie électrique 3, et / ou en fonction du rapport cyclique, en particulier lorsque ce dernier est déterminé par une méthode de recherche MPPT s'avère importante pour une optimisation du rendement total du circuit convertisseur 2.

Pour la commande des commutateurs à dimensions réglables 17 et 25 dont l'état ouvert ou fermé détermine si la sortie 19 du circuit de hachage 11 est reliée directement à la charge 23 ou à l'accumulateur d'énergie électrique 29, le circuit de commande 51 comporte un comparateur à hystérésis 61 dont une entrée est raccordée au premier circuit de sortie 14 et dont l'autre entrée est raccordée à une référence 63, la sortie du comparateur 61 étant raccordée à une entrée de l'unité de commande 53.

Pour le fonctionnement, l'unité de commande 53 commande le générateur 55 de façon que

- quand le commutateur 13 est fermé (état passant), les commutateurs 17 et 25 sont ouverts (étant bloquant),
- quand l'un des commutateurs 17 ou 25 est fermé (état passant), l'autre 25 ou 17 est toujours ouvert (état bloquant) et le commutateur 13 est ouvert (état bloquant).

Ainsi, à un moment donné, seul un des commutateurs 13, 17 ou 25 ne peut être à l'état ouvert, les deux autres étant à l'état fermé.

Par la suite, on va détailler le fonctionnement du circuit convertisseur 2 de la figure 4.

Le convertisseur de la figure 4 fonctionne autour du point maximal de puissance MPP de la même façon que le circuit de la figure 1.

Ainsi, le circuit convertisseur 2 oscille autour du point de fonctionnement maximal MPP, ce qui garantit de récupérer un maximum de puissance disponible à la source.

Comme cela a été dit précédemment, lorsque le commutateur 13 est fermé, les commutateurs 17 et 25 sont ouverts et l'inductance est parcourue par un courant fourni par la source 3 établissant un champ magnétique.

Puis, le commutateur 13 est ouvert et l'énergie électrique peut être fournie soit directement à la charge 23 pour une consommation directe en ouvrant le commutateur 17, soit être stocké dans l'accumulateur 29 pour une consommation ultérieure.

Le circuit de sortie 14 fonctionne donc ensemble avec le circuit de hachage 11 comme un régulateur de tension.

Ainsi, lorsque le commutateur 13 est ouvert, le commutateur 17 s'ouvre si la tension de sortie est comprise dans une plage de consigne de tension de sortie.

Cette plage de consigne est définie par l'intermédiaire du comparateur à hystérésis 61 et la référence 63.

Lorsque la tension de sortie est en dehors de la plage de consigne, l'unité de commande 53 reçoit du comparateur 61 un signal correspondant et commande l'ouverture du commutateur 25 si le commutateur 13 est toujours ouvert.

Ainsi, l'énergie électrique générée par la source 3 peut être récupérée de façon optimale soit pour une consommation directe de la charge 23, soit pour charger l'accumulateur 29.

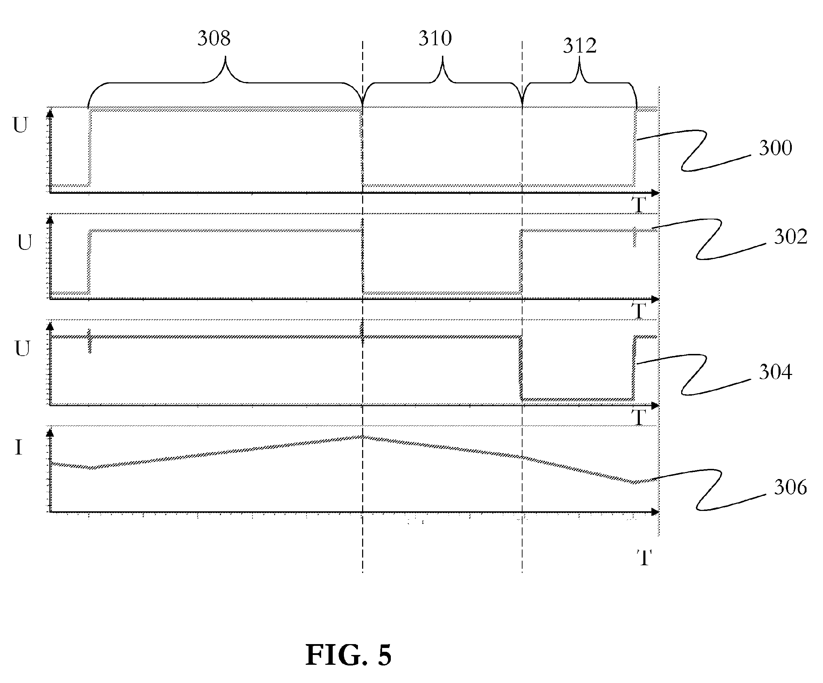

Ce fonctionnement est aussi illustré sur la figure 5.

Les courbes 300, 302 et 304 montrent respectivement les tensions commande U des commutateurs 13, 17 et 25 en fonction du temps. Il est rappelé que le commutateur 13 est un transistor du type NMOS tandis que les commutateurs à dimension réglable 17 et 25 sont du type PMOS dans le présent exemple de réalisation.

La courbe 306 montre l'évolution du courant à la borne de sortie 19.

Ainsi, lors de l'intervalle de temps 308, la tension de commande des commutateurs 13, 17 et 25 est à un niveau haut, ce qui signifie que le transistor NMOS 13 est passant et l'inductance 12 se charge tandis que les transistors PMOS 17 et 25 sont à l'état bloquant.

Puis, lors de l'intervalle de temps 310, la tension de commande des commutateurs 13 et 17 est à un niveau bas, ce qui signifie que le transistor NMOS 13 est bloquant et l'inductance 12 se décharge par le circuit de sortie 14 (voir courbe 306) étant donné que le transistor PMOS 25 est alimenté par une tension de niveau haut et donc à l'état bloquant. La durée de cet intervalle de temps 310 dépend du fait si la tension de sortie est comprise dans la plage de consigne. Elle dépend donc de l'énergie produite par la source et du courant consommé par la charge 23.

Lorsque la tension de sortie se trouve en dehors de la plage de consigne de tension de sortie et que la tension de sortie du commutateur NMOS est toujours au niveau bas, donc à l'état bloqué, le commutateur 17 passe lors de l'intervalle de temps 312 à l'état bloquant tandis que le commutateur 25 passe à l'état passant et l'inductance se décharge maintenant vers le circuit de sortie 15 pour recharger l'accumulateur 29.

L'utilisation de l'énergie emmagasinée dans l'accumulateur 29, par exemple par la charge 31, se fait de façon traditionnelle, en cas de besoin, via le régulateur 33 et ne sera pas décrit plus en détail.

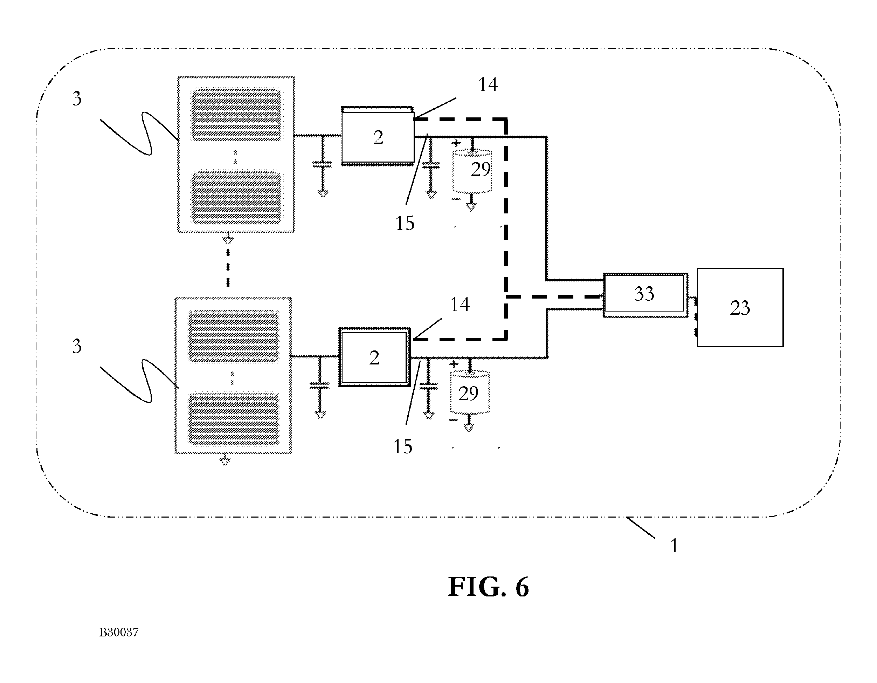

La figure 6 montre un schéma d'un système électrique comprenant plusieurs cellules photovoltaïques dont chacune est associée à un circuit convertisseur 2 comme celui par exemple de lafigure 4.

Dans ce cas, les premier circuits de sorties 14 sont raccordées ensemble pour fournir une alimentation stabilisée locale et chacun des seconds circuits de sortie 15 des circuits convertisseurs 2 comprend un supercondensateur ainsi qu'un régulateur de tension DC-DC 33.

La récupération d'énergie est ainsi optimisée étant donné que les cellules sont rendues indépendantes entre-elles, ce qui prévient le fait qu'une cellule par exemple ombragée devient une charge pour les autres cellules et fait chuter le rendement de récupération énergétique.

De plus, un tel montage permet que chacune des cellules puisse fonctionner à son point maximal de puissance indépendamment des autres cellules photovoltaïques.

Enfin, lorsque le supercondensateur est assez chargé, il peut délivrer son énergie via le régulateur 33.

On comprend donc que le circuit convertisseur 2 selon l'invention permet une optimisation de la récupération d'énergie en réduisant les pertes au niveau des commutateurs de puissance.

Le circuit se distingue aussi par sa simplicité de fonctionnement et son faible besoin en ressources énergétiques et de calcul.

En particulier pour des capteurs autonomes, il permet un dimensionnement plus petit des piles / batteries alimentant le capteur lorsque la source ne fournit pas ou pas assez d'énergie.

## Revendications

1. Circuit convertisseur (2) destiné à être relié à une source d'énergie électrique (3) susceptible de fluctuations importantes de puissance délivrée, comprenant :

   - un circuit de hachage (11) à rapport cyclique ($\alpha$) variable, comprenant un commutateur de hachage (13) à dimension réglable et une borne d'entrée (9) susceptible d'être reliée à ladite source d'énergie électrique (3), et
   - au moins un premier circuit de sortie (14) adapté à être connecté via un commutateur (17) à dimension réglable à une borne de sortie (19) du circuit de hachage (11),
   - un circuit de commande (51) configuré pour commander d'une part le rapport cyclique ($\alpha$) du circuit de hachage et d'autre part la dimension desdits commutateurs (13,17) à dimension réglable en fonction de la puissance délivrée par ladite source d'énergie électrique (3).

2. Circuit convertisseur (2) selon la revendication 1, dans lequel le circuit de commande (51) est configuré pour commander la dimension desdits commutateurs à dimension réglable (13,17) en fonction du rapport cyclique ($\alpha$).

3. Circuit convertisseur (2) selon la revendication 2, dans lequel le circuit de commande (51) est configuré pour rechercher le point maximum de puissance (MPPT).

4. Circuit convertisseur selon la revendication 3, dans lequel ledit circuit de commande (51) est configuré pour déterminer un point de fonctionnement (MPPT) en fonction de la variation de tension de ladite source d'énergie électrique (3).

5. Circuit convertisseur selon l'une quelconque des revendications 1 à 4, dans lequel chacun desdits commutateurs à dimension réglable comprend au moins deux commutateurs individuels (130, 132, 134) disposés en parallèle et commutables sélectivement en fonction d'une commande dudit circuit de commande (51).

6. Circuit convertisseur selon la revendication 5, dans lequel les commutateurs individuels (13 0, 132, 134) sont de même dimensions.

**7.** Circuit convertisseur selon la revendication 5, dans lequel les commutateurs individuels (130, 132, 134) possèdent des dimensions croissantes.

**8.** Circuit convertisseur selon la revendication 7, dans lequel les commutateurs individuels (130, 132, 134) possèdent des dimensions croissantes par des multiples de deux.

**9.** Circuit convertisseur selon l'une quelconque des revendications 1 à 8, dans lequel le circuit de commande (51) est configuré pour commander une augmentation de la dimension desdits commutateurs (13,17) à dimension réglable en fonction d'une augmentation de la puissance délivrée par ladite source d'énergie (3).

**10.** Circuit convertisseur selon la revendication 9, dans lequel le circuit de commande (51) est configuré pour commander la dimension desdits commutateurs à dimension réglable en fonction de plages de consigne prédéfinies de puissance délivrées par ladite source d'énergie.

**11.** Circuit convertisseur selon l'une quelconque des revendications 1 à 10, dans lequel le circuit de commande est configuré pour commander le circuit de hachage selon un fonctionnement discontinu.

**12.** Circuit convertisseur selon l'une quelconque des revendications 1 à 11, dans lequel il comprend un second circuit de sortie (15) adapté à être connecté via un second commutateur (25) réglable en dimension à la borne de sortie (19) du circuit de hachage (11), et dans lequel le circuit de commande est configuré pour commander la commutation des premier (17) et second commutateurs (25) en fonction d'une plage de consigne de tension de sortie pour le premier circuit de sortie (14).

**13.** Circuit convertisseur selon la revendication 12, dans lequel le premier circuit de sortie (14) est destiné à être raccordé à une charge électrique (23) fonctionnant dans la plage de consigne de tension et dans lequel le second circuit de sortie (15) est destiné à être raccordé à un accumulateur d'énergie électrique (29).

**14.** Circuit convertisseur selon la revendication 13, **caractérisé en ce que** le circuit de commande (51) comporte un comparateur à hystérésis (61) dont une entrée est raccordée au premier circuit de sortie (14) et dont l'autre entrée est raccordée à une référence (63), la sortie du comparateur (61) étant raccordée à une entrée d'une unité de commande (53) commandant un générateur de commande (55) dont deux sorties sont respectivement reliées aux premier (17) et second (25) commutateurs pour leur pilotage respectif.

**15.** Circuit convertisseur selon la revendication 12 ou 13, dans lequel l'accumulateur d'énergie électrique (29) est une micro-pile rechargeable.

**16.** Circuit convertisseur selon la revendication 12 ou 13, dans lequel l'accumulateur d'énergie électrique (29) est un supercondensateur.

**17.** Circuit convertisseur selon l'une quelconque des revendications 1 à 16, dans lequel les circuits de sortie (14, 15) comprennent des filtres passe - bas (21, 27).

**18.** Circuit convertisseur selon l'une quelconque des revendications 1 à 17, dans lequel le circuit de commande (51) comprend en outre des moyens pour

- déterminer la tension aux bornes de ladite source d'énergie électrique pour deux rapports cycliques différents d'une quantité prédéfinie,
- calculer la différence entre les tensions obtenues pour deux rapports cycliques différents d'une quantité prédéfinie,
- comparer cette différence de tension avec une valeur de différence de tension obtenue précédemment, et
- commander un changement du rapport cyclique ($\alpha$) d'une quantité prédéfinie ($\Delta\alpha$) en fonction du résultat de comparaison.

**19.** Circuit convertisseur selon la revendication 18, dans lequel le circuit de commande (51) est configuré pour commander une augmentation du rapport cyclique ($\alpha$) d'une quantité prédéfinie ($\Delta\alpha$) si une diminution précédente du rapport cyclique a eu pour résultat une diminution de la différence de tension par rapport à celle obtenue lors de la détermination précédente.

**20.** Circuit convertisseur selon la revendication 19, dans lequel le circuit de commande (51) est configuré pour commander une diminution du rapport cyclique ($\alpha$) d'une quantité prédéfinie ($\Delta\alpha$) si une augmentation précédente du rapport cyclique a eu pour résultat une diminution de la différence de tension par rapport à celle obtenue lors de la détermination précédente.

**21.** Circuit convertisseur selon l'une quelconque des revendications précédentes, dans lequel le circuit de hachage (11) comprend une inductance d'accumulation d'énergie électrique (12) et au moins un commutateur de hachage (13) commandé par le circuit de commande (51).

**22.** Circuit convertisseur selon la revendication 21, dans lequel l'inductance d'accumulation d'énergie électrique (12) et le commutateur de hachage (13) sont disposés selon une configuration élévateur de tension.

**23.** Circuit convertisseur selon la revendication 21, dans lequel l'inductance d'accumulation d'énergie électrique (12) et le commutateur de hachage (13) sont disposés selon une configuration abaisseur de tension.

**24.** Circuit convertisseur selon l'une quelconque des revendications 21 à 23, dans lequel le circuit de commande comporte un capteur de courant « zéro » (59) de l'inductance d'accumulation d'énergie électrique pour déclencher la commande d'au moins un commutateur (17, 25).

**25.** Système électronique (1) comprenant au moins une source d'énergie électrique (3) susceptible de fluctuations importantes et au moins un circuit convertisseur (2) selon l'une quelconque des revendications 1 à 24 relié à ladite au moins une source d'énergie (3).

**26.** Système électronique selon la revendication 25, dans lequel ladite source (3) comprend au moins une cellule photovoltaïque.

**27.** Système électronique selon la revendication 25, dans lequel ladite source (3) comprend au moins une éolienne.

**28.** Système électronique selon la revendication 25, dans lequel ladite source (3) comprend au moins un élément thermoélectrique.

**FIG. 1**

B30037

**FIG. 2**

$$(\alpha k+1) = (\alpha k) - \Delta\alpha$$

$$(\alpha_k +1) = (\alpha_k) + \Delta\alpha$$

208

208

**FIG. 3**

B30037

EP 2 393 193 A1

**FIG. 4**

B30037

300

302

304

306

312

310

308

U

U

U

I

T

FIG. 5

FIG. 6

Europäisches
Patentamt

European
Patent Office

Office européen
des brevets

# RAPPORT DE RECHERCHE EUROPEENNE

Numéro de la demande

EP 11 16 8131

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2005/280401 A1 (PLANKENSTEINER MANFRED [DE]) 22 décembre 2005 (2005-12-22) * alinéa [0009] - alinéa [0011]; figure 2 * ----- | 1 | INV. H02M3/158 H02J3/38 H03K17/12 |
| A | US 2008/265851 A1 (ZHANG JASON [US]) 30 octobre 2008 (2008-10-30) * alinéa [0007] - alinéa [0008]; figure 2 * ----- | 1 | |
| A | EP 2 117 121 A1 (SCHLEIFRING UND APPBAU GMBH [DE]) 11 novembre 2009 (2009-11-11) * abrégé; figure 1 * ----- | 1 | |

| | | | DOMAINES TECHNIQUES RECHERCHES (IPC) |
|---|---|---|---|
| | | | H02M H03K G05F H02J |

Le présent rapport a été établi pour toutes les revendications

| Lieu de la recherche | Date d'achèvement de la recherche | Examinateur |
|---|---|---|
| La Haye | 15 août 2011 | Imbernon, Lisa |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 11 16 8131

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-08-2011

| Document brevet cité au rapport de recherche | | Date de publication | Membre(s) de la famille de brevet(s) | | Date de publication |
|---|---|---|---|---|---|
| US 2005280401 | A1 | 22-12-2005 | AUCUN | | |
| US 2008265851 | A1 | 30-10-2008 | AUCUN | | |
| EP 2117121 | A1 | 11-11-2009 | US 2009296441 A1 | | 03-12-2009 |

EPO FORM P0460

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060038543 A